Europäisches Patentamt

European Patent Office

Office européen des brevets

⑩

(11) Publication number: **0 043 457**
**B1**

(12) **EUROPEAN PATENT SPECIFICATION**

(45) Date of publication of patent specification: **23.04.86**

(21) Application number: **81104436.1**

(22) Date of filing: **10.06.81**

(51) Int. Cl.⁴: **B 65 G 51/00, H 01 L 21/68**

(54) **Air film transportation device.**

(30) Priority: **03.07.80 US 165579**

(43) Date of publication of application:
**13.01.82 Bulletin 82/02**

(45) Publication of the grant of the patent:
**23.04.86 Bulletin 86/17**

(84) Designated Contracting States:
**DE FR GB**

(56) References cited:
**AT-B- 354 345**
**GB-A-1 288 686**
**US-A-3 272 415**
**US-A-3 385 490**
**US-A-4 081 201**

(73) Proprietor: **International Business Machines**
**Corporation**
**Old Orchard Road**
**Armonk, N.Y. 10504 (US)**

(72) Inventor: **Hassan, Javathu Kutikaran**
**55 Wright Boulevard**
**Hopewell Junction, N.Y. 12533 (US)**
Inventor: **Paivanas, John Angelo**
**10 Hudson Drive**
**Hyde Park New York 12538 (US)**

(74) Representative: **Brügel, Gerhard, Dipl.-Ing.**
**Schönaicher Strasse 220**
**D-7030 Böblingen (DE)**

Courier Press, Leamington Spa, England.

# Description

The present invention relates generally to the transportation of objects, such as semiconductor wafers, along a track on an air film and, more particularly, relates to an improved air film wafer transportation system of simplified construction and having improved stability during the transportation of wafers along a desired track.

It is desirable to transport semiconductor wafers on a lubricating film of air or other gas in an effort to minimize physical contact. Generally, transportation of wafers along an air film track entails the use of flat perforated surfaces through which a continuous supply of air under pressure is forced. These surfaces are either a porous sintered material or a material containing an array of small holes. When a wafer is located over the air streams issuing from the holes at the surface, a cushioning air film is formed which supports the wafer. The wafer is moved and maneuvered by the impulse action of air streams issuing from oriented openings.

An additional requirement for air film transportation is some means to constrain the wafer during transportation along the air track to prevent the wafer from departing from the track. Various forms of solid constraining means have been used. One such air film transportation system without solid constraining means is described in U.S. Patent No. 4 081 201 to Hassan et al. The Hassan et al. patent describes an air track making use of an axi-radial effect and a Coanda effect which are generated by a track surface construction containing rows of long air feed nozzles separated by evacuating channels. The sides of the passages are inclined toward the axis of symmetry of the track surface and the flat region in which they terminate are bounded on the axis of symmetry side by a smoothly curving surface forming the sidewall of one of the channels.

The air film produced by the configuration of the Hassan et al. patent can be considered as a controlled flow volume of an essentially constant film thickness, bounded by the track surface on one side and the wafer surface on the other side. The controlled volume fluid generates forces acting on the wafer of a given weight, in directions both normal to and in the plane of the wafer surface. These forces are a calculated result of the combined effects of the axi-radial effect and Coanda flow phenomena. The air film transportation system described in the Hassan et al. patent is capable of moving semiconductor wafers along a track without the need for solid constraining barriers to hold the semiconductor wafer on the track.

While the air film transportation system described in the aforementioned Hassan et al. patent has been highly successful, it nevertheless has certain limitations from the standpoints of constructional requirements as well as performance characteristics. Specifically, the system employs a rather large number of long, small-diameter, air film feed holes which involves a considerable construction operation. The multidirectional wafer motion control properties produced by the air film represent a compromise between ideal fluid mechanics effects, as associated with a single hole, and the actual lessened effects due to cross-interference flow action between the multiple air film feed holes. Thus, while the resultant air film control forces produced by the aggregate action of the holes is very effective in providing stable wafer transportation, limitations of this effectiveness still exist owing to the presence of the encroaching cross-interference flow effects. From another standpoint, this overall control effectiveness is achieved for a range of air supply flow rates which, however, can be appreciable for certain practical conditions. This is especially the case for large track installations in which substantial air supply requirements would be involved. Thus, in addition to providing an air film transportation system of further simplified construction which is more economical to produce, operate and maintain, it is desirable to achieve this while greatly improving the wafer motion control capabilities of the system.

In order to solve this problem, according to the present invention, a device for transporting objects on a bed of a gaseous fluid comprising a substantially elongated transporting track is arranged, having rows of holes extending longitudinally, the rows being arranged symmetrically in pairs about a center line and each row being separed from adjacent rows by parallel channels, said holes in each row being spaced longitudinally at equal distances along said track as it is already known from the US—A—4,081,201, which device is characterized in that said holes in each row on each side of said center line are longitudinally spaced from the holes in each adjacent row, such that a series of imaginary lines joining adjacent holes across the width of the device are parallel and form a regular herringbone pattern swept-back in the direction of transport and symmetrical about said center line, whereby the spacing distance between the holes in each row is X and the longitudinal spacing distance between adjacent holes in each two adjacent rows is a constant distance of from about X/4 to about 3X/4, preferably X/2.

According to the invention a track for transporting objects such as semiconductor wafers on a bed of a gaseous fluid is provided making improved use of an axi-radial effect and a Coanda effect. The track surface construction contains rows of air feed nozzles separated by evacuating channels. The rows of holes on each side of the center line of the air track are oriented such that the holes in adjacent rows are spaced longitudinally along the track. The use of longitudinal spacing of the holes in adjacent rows permits the use of a reduced number of holes for the overall track configuration. Surprisingly, the use of spaced holes also provides improved stability for the wafers as they are transported along the track.

The air film produced by the configuration of holes used in the air track of the invention provides greatly improved forces acting normal to and parallel to the surface of the wafer being transported along the air track, and improved stability is attained as the wafer is transported along the track. The hole configuration of the air track of the present invention provides an improved result making use of the combined effects of the axi-radial effect and the Coanda flow phenomena.

Thus, the invention provides a wafer transportation system, which has improved minimal movement of the wafer in directions other than the desired direction of transportation, and features improved simplicity of construction, reduced air supply requirements, and improved stability during transportation of the wafers.

Details of the invention will become more apparent from the following detailed description and the accompanying drawings in which:

Figure 1 is a plan view of a section of track for the wafer transportation system;

Figure 1A is a plan view of a section of Figure 1 further illustrating details of construction;

Figure 2 is a side view of the section of track of Figure 1;

Figure 3 is a sectional view taken along line 3—3 in Figure 1;

Figure 4 is an expanded view of a portion of Figure 1;

Figure 5 is a section taken along line 5—5 in Figure 4;

Figure 6 is a graph of the flow static pressure vs. distance from the center line of the passageway illustrated in Figure 4;

Figure 7, taken along line 7—7 in Figure 1, is a more general view of Figure 3 and illustrates the forces exerted on the wafer in the normal and planar directions;

Figure 8 is a graph of the height of the wafer over the track surface as a function of the air supply flow rate;

Figure 9 is a plot of the velocity profile associated with the fluid shear force acting on the wafer;

Figure 10 is a schematic representation of the planar transverse force action on the wafers as they move along the track;

Figure 11 is a graph of transverse restraining force acting on wafers associated with the motion illustrated in Figure 10;

Figure 12 is an enlarged view of a portion of the track shown in Figures 1 and 1A; and

Figure 13 is a plan view of a section of track showing a further embodiment of the invention.

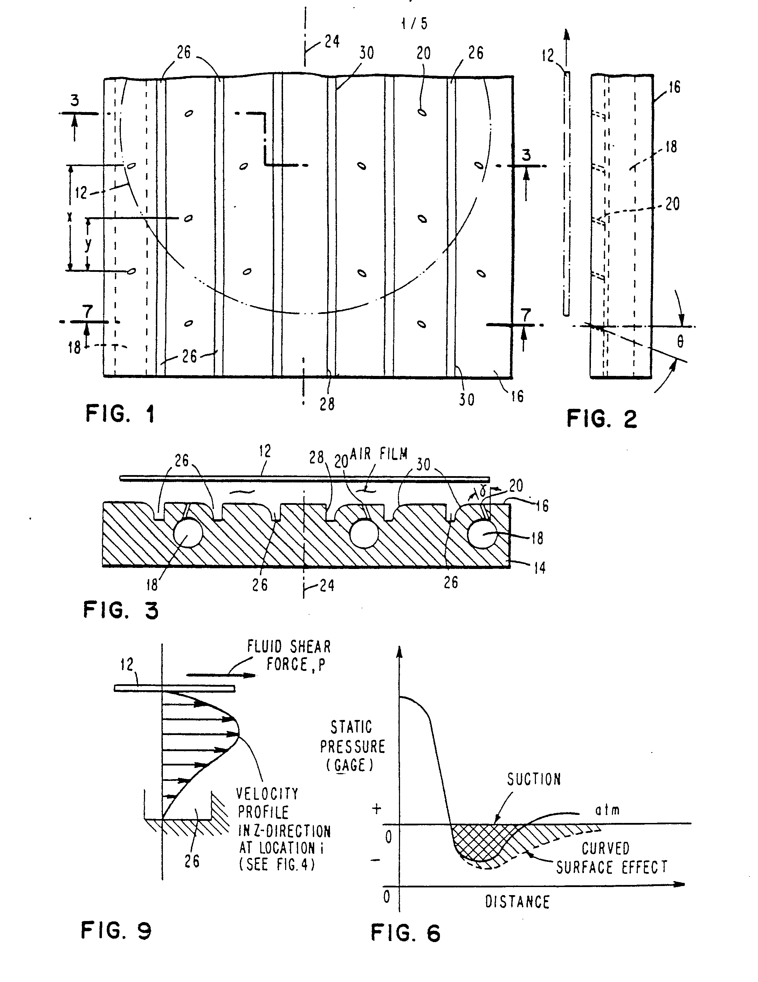

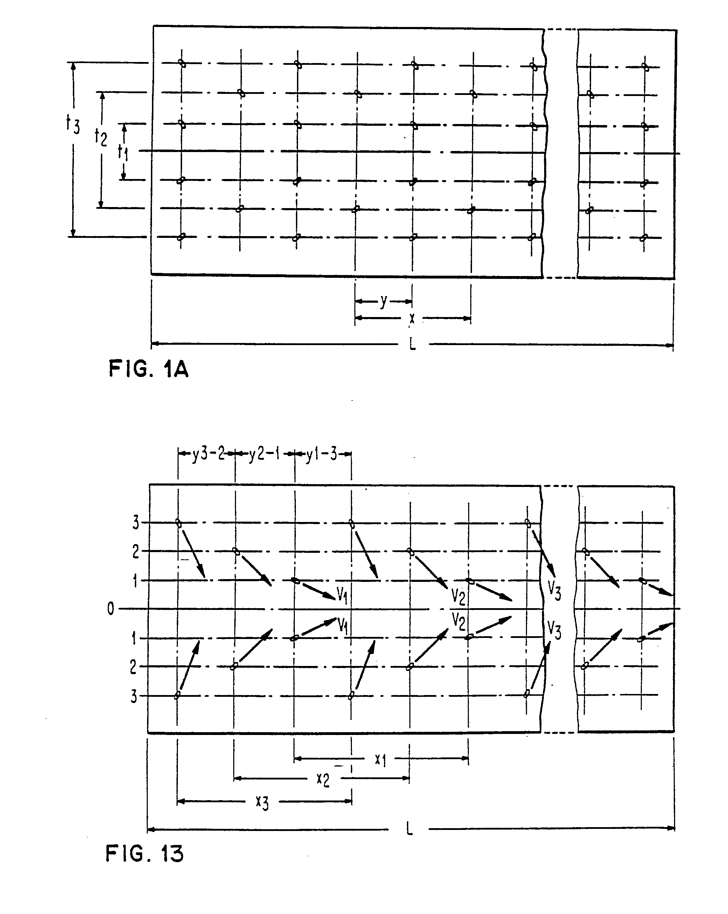

Referring now to Figures 1 to 3, a semiconductor wafer 12 is transported over a track 14 on an air film fed to the top surface 16 of the track from air manifolds 18 in the track 14 through nozzles with long thin passages 20 arranged in six rows positioned symmetrically around the center line 24 of the track 14. These passages are inclined with respect to the vertical at an angle γ in the direction of the centerline and at an angle θ in the direction of motion along the track. An exhaust channel 26 is formed in the track 14 on the centerline side of each row of nozzles. These exhaust channels are asymmetrical in cross section in that the wall 28 towards the centerline is vertical and straight while the exterior wall 30 is curved with a radius R and terminates tangentially with the top surface 16 of the track.

More particularly, the orientation of the holes in adjacent rows on each side of the centerline of the track 14 is used to provide the benefits of the invention in respect to simplified construction and improved stability. As shown in Figure 1, the rows of holes may be regarded as pairs of rows with one of each pair located on the opposite sides of the centerline and spaced equidistant from the centerline. The holes in each pair of rows are spaced longitudinally equidistant along the track 14. The spacing distance is denoted by the symbol "x". Typical values of x range from about 2,7 mm to about 22,9 mm and are the same for holes in each row. In the most simple embodiment of the present invention, two pairs of rows are used. In the embodiment illustrated in Figure 1, three pairs of rows are shown and the following discussion will refer to the three row embodiment of Figure 1. It should be understood that more than three pairs of rows can be used but that no substantial benefit is attained and that some of the advantages of simplified construction are lost.

Referring to Figure 1, a further requirement of the improved air track of the invention is that the holes in each row on each side of the centerline are longitudinally spaced from the holes in each adjacent row by a spacing distance denoted by the symbol "y". The longitudinal spacing distance y is preferably from about $x/4$ to about $3x/4$ and is most preferably equal to about $x/2$.

The above aspects are further illustrated by Figure 1A which shows a hole pattern for a typical track segment construction of overall length L. The three pairs of rows are symmetrically spaced with respect to the longitudinal centerline at distances $t_1$, $t_2$ and $t_3$. The holes in each row are spaced at a distance $x=2a$, and each pair of rows is alternately staggered in a longitudinal direction such that $y=x/2=a$ for this particular construction. Thus, the track segment of length L embodies, in effect, a symmetrical arrangement of longitudinally spaced hole columns (a column being defined as a line of holes extending in a direction perpendicular to the centerline), each column spaced at a distance "a". The columns contain four holes or two holes in an alternating sequence. The first and last columns are spaced at a distance $a/2$ from the segment extremities. Thus, a longitudinal but joint assembly of a given set of track segments to effect a larger installation provides a row spacing "a" at the segment junction regions.

The top surface of the track and the wafer are enclosed in a clear plastic cover (not shown). This cover is to provide a barrier from dust and dirt and does not constitute a boundary for the movement of the wafer and the wafers do not

contact the cover. For instance, a silicon wafer 83 mm (3.25 inches) in diameter and 0.38 mm (15 mils) thick can be transported over a track of the type described with sufficient control of the wafer to eliminate the need of wafer guides when the track is constructed and operated to the specifications set forth in the following paragraph.

The film hole inclinations $\gamma$ and $\theta$ could be the same for all the film holes. This represents one constructional situation. If this were the case these angles, for example, would be $\gamma=15°$ and $\theta=10°$. However, marked advantages in wafer motion control can be obtained by changing film hole angles $\gamma$ and $\theta$ for each pair of rows.

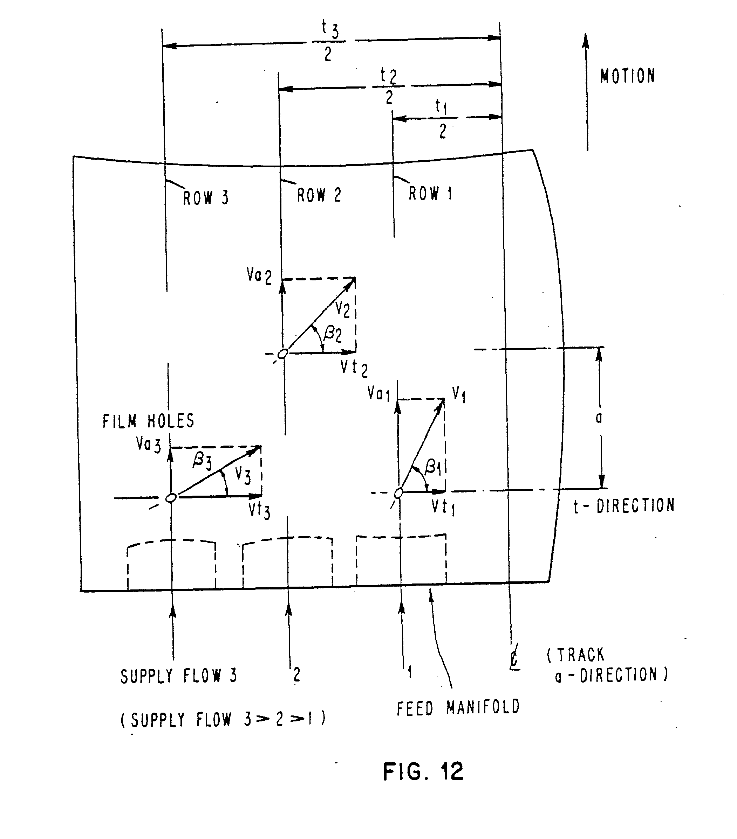

Figure 12 shows the left half of three pairs of rows numbered 1, 2 and 3 and spaced at distances $t_1$, $t_2$ and $t_3$ with reference to the longitudinal centerline. Rows 1 and 3 have no longitudinal displacement and row 2 is longitudinally displaced by a distance equivalent to the hole space "a". Each row has a particular set of angles $\gamma$ and $\theta$. Thus, at row 1 the film hole angles $\gamma$ and $\theta$ are such that planar velocity components $V_{a1}$ and $V_{t1}$ exist and where $V_1$ is the planar resultant inclined at the corresponding compound angle $\beta_1$. Similarly, the $\gamma$, $\theta$ values for other rows are implemented so as to obtain the qualitative vector picture shown in Figure 12. In addition to the angular difference, vectors $V_1$, $V_2$ and $V_3$ are different in magnitude because of the different supply flow rates in corresponding manifolds. Thus, $V_3 > V_2 > V_1$ reflect the supply flow rate variation, viz., flow rate 3> flow rate 2> flow rate 1.

The underlying reason for the film hole angular variations just described is to give a much improved transverse stability to the moving wafer. When the wafer center of gravity (C.G.) is moving along the a-axis, the transverse velocity components $V_a$ dominate in producing fluid forces to propel the wafer. If the C.G. moves in the t-direction while the wafer moves down the track, the $V_a$ induced fluid forces diminish with deviation distance, t, while $V_t$ increases progressively to provide more effective transverse restoring force. The overall result is a stronger resistance to deviation from motion along the centerline. Furthermore, when this condition does occur, the recovery (damping) is more rapid.

Typical film hole angles for the film hole rows are as follows:

row 1: $\gamma=10°$, $\theta=20°$

row 2: $\gamma=15°$, $\theta=15°$

row 3: $\gamma=20°$, $\theta=10°$

Row spacings can vary somewhat without sensitive influence on wafer motion. For example, typical spacings for both 83 mm (3.25 inch) and 57 mm (2.25 inch) wafers are as follows:
$t_1=22,2$ mm (7/8 inch) to 25,4 mm (1 inch)
$t_2=50,8$ mm (2 inches) to 52,4 mm (2-1/16 inches)
$t_3=73$ mm (2-7/8 inch) to 76,2 mm (3 inches).

Film hole diameters range from 0,34 mm (0.0135 inch) to 0,64 mm (0.025 inch) and lengths range from 1,65 mm (0.065 inch) to 3,05 mm (0.12 inch). A typical track uses 0,34 mm (0.0135 inch) diameter film holes for lengths ranging from approximately 1,65 mm (0.065 inch) to 1,93 mm (0.076 inch); the variation in lengths being due to the different inclination angles $\gamma$ and $\theta$.

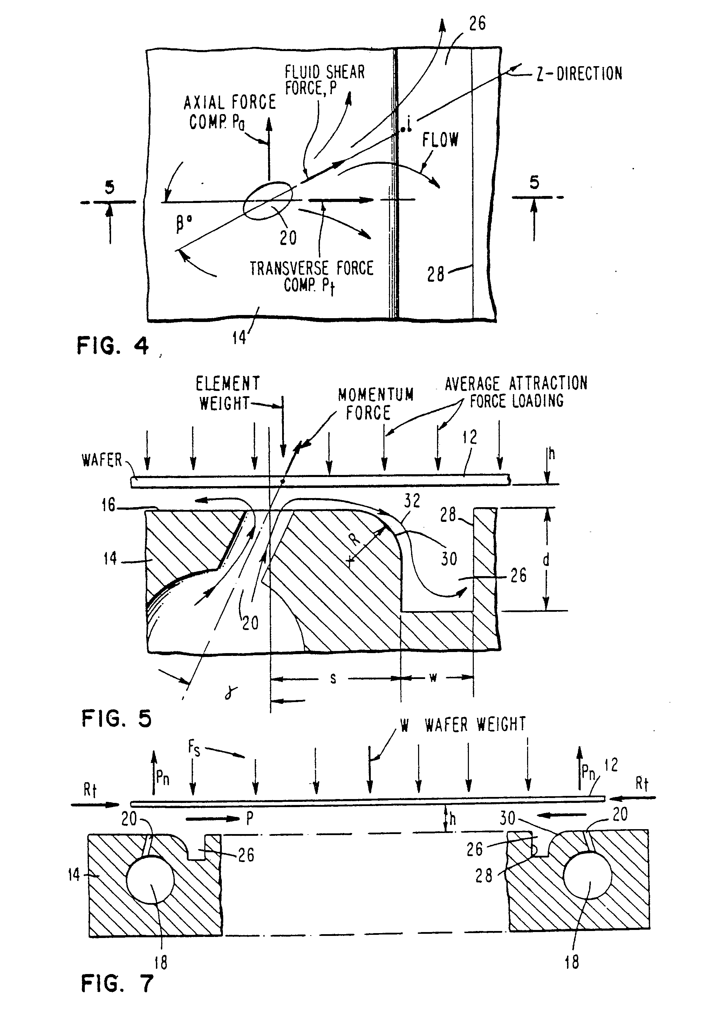

Referring to Figure 5, the following typical dimensions are used in the track:
channel radius R=3,18 mm (0.125 inch)
distance s=6,35 mm (0.250 inch)
distance d=3,18 mm (0.125 inch)
distance w=1,83 mm (0.072 inch).

This set of dimensions represents one of a number of other practical conditions. For example, the channel radius R can be varied to augment transverse stability on the track. In other applications such as an orientor, or an intersection, the radius becomes less important because the axial wafer momentum force is absent. Indeed, a radius $R \simeq 0$ is used in some designs.

Referring back to Figure 12, the manifold supply flow rate is set by placing a manometer total pressure tube over passage or film hole 20 and adjusting manifold pressure to give desired manometer readings. Thus, typical stagnation pressures for the film hole rows as measured by the manometer are as follows:
row 1: 152 to 254 mm (6 to 10 inches) water column
row 2: 381 to 508 mm (15 to 20 inches) water column
row 3: 711 to 864 mm (28 to 34 inches) water column.

The common reservoir for the manifold has a pressure in the order of 0,1 to 0,14 bar (1.5 to 2 psig) upstream of the three adjustment valves for the film hole rows.

Referring now to Figure 5, air issuing from any one of the array of film holes 20 within the control volume strikes the wafer 12 and undergoes an abrupt change in flow direction. This change in direction results in a flow separation over the track surface which produces the static pressure variation in the radial direction which is shown in Figure 6. The integrated effect of this variation, over a given surface area around the film hole, is both to attract and repel the wafer 12 by producing both an attracting and repelling force on the wafer. (One aspect of the curved exterior wall surface 30 is that it acts to extend the attraction force over a wider region.)

The repelling force from the film hole acts to repel the wafer 12 from the track 14. This, however, is prevented by the coexisting attraction force and the weight of the wafer. The net result is that for a given air flow rate, a state of dynamic equilibrium occurs at a certain film thickness h, where the forces balance, in a direction normal to the track surface. The film thickness is characteristically constant and its value, for a given element weight, depends on the air flow rate. Any tendency of the element to tilt relative to the track surface is continuously counteracted.

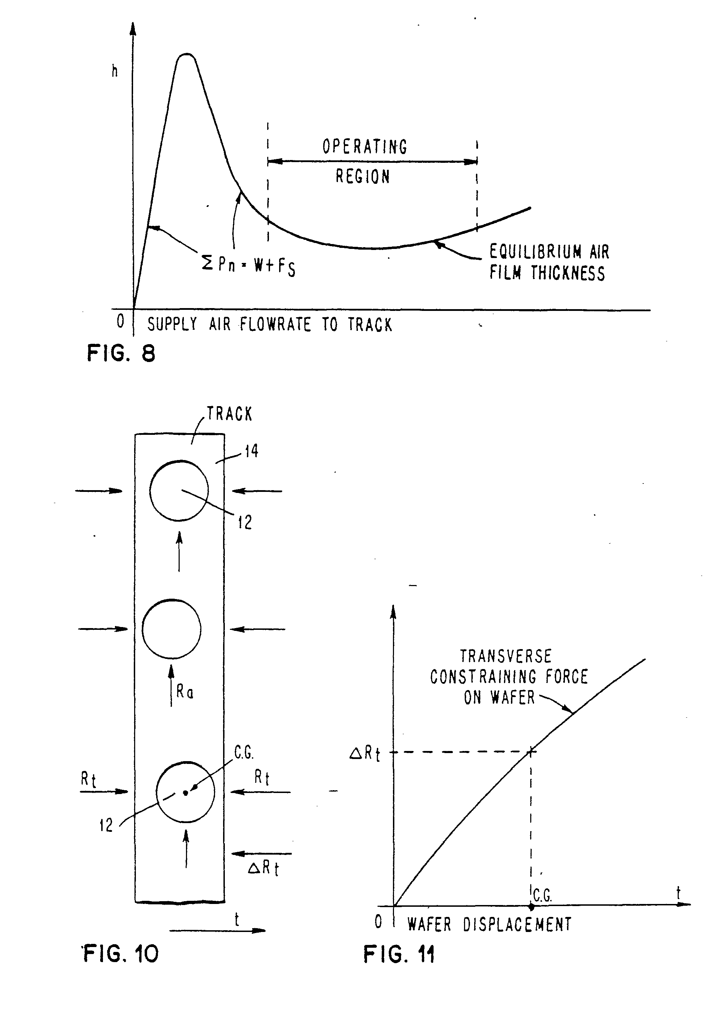

This analysis can be extended to the entire wafer surface bounding the upper side of the control volume. As shown in Figure 7, the wafer 12 of weight W is subjected to an average force $F_s$ due to the combined suction effects of the film holes in the control volume or in other words, the air volume under the wafer. This force acts in the normal direction and is opposed by the sum of normal momentum force components of the film hole flows, namely $\Sigma P_n$. The dynamic equilibrium condition, at the film thickness h, is thus $\Sigma P_n = W + F_s$. The control volume air film embodying this action of normal forces exerts a continuous, uniform, stabilizing effect on the wafer in the normal direction. Thus, as the wafer moves in the axial direction it does so at an essentially constant film thickness h due to this overall motion constraint. The magnitude of the constant film thickness is, for other conditions fixed, a function of the air flow rate. This variation of h with track flow rate is illustrated in Figure 8. Since the relationship $\Sigma P_n = W + F_s$ exists for each value of h, the shape of the curve reflects the relative magnitudes of the quantities $P_n$, W, and $F_s$. A variation in the wafer weight W, for example, is reflected by a shift to a new equilibrium value of h.

Up to this point the discussion has been focused on motion constraint properties in a direction normal to the air track and wafer surfaces. In addition to these properties, there coexist motion control forces in directions parallel to the wafer surface. The forces are incorporated into the air film by use of the Coanda effect in conjunction with the axi-radial phenomenon.

One kind of force in the plane of the wafer is due to the planar components of the momentum repelling force acting on the wafer element. These components are introduced by inclining the film holes (i.e., at angles γ and θ) so that planar components normal to, and parallel to, the track longitudinal axis are obtained. Thus, as shown in Figure 4, this resolution consists of axial and transverse momentum force components on the wafer element, at each film hole site. The second kind of force in the plane of the wafer is due to the boundary layer induced frictional forces associated with the air flow parallel to the wafer surfaces. To illustrate this, a typical velocity profile is shown in Figure 9. This profile represents the variation of the parallel flow velocity components with normal distance in the air film. In accordance with boundary layer theory, the flow shear force is proportional to the rate-of-change of this velocity, taken at the wafer surface. Hence, a fluid shear force is produced on the wafer element surface. The magnitude of this force, for other conditions equal, depends on the shape of the velocity profile in the neighborhood of the wafer surface (i.e., the greater the velocity rate-of-change, the higher the shear force). The channel action promotes a profile of the kind illustrated which, in turn, is very effective in the above process.

The combined effect of the above two kinds of forces is represented by the resultant planar force vector acting in the Z-direction, as shown in Figure 4. The constituent momentum and shear forces increase as the air flow rate is increased. For a given flow rate, the average velocity of the flow parallel to the wafer surface changes with distance from the film hole. Consequently, this is reflected in a corresponding variation of the shear force acting on the wafer surface. In the present case, the coupled action of the axi-radial suction region and the channel produce a unique net effect with regard to the shear force characteristics. First, the flow separation over the suction region results in a high velocity parallel to the wafer surface. Second, the curved surface in "pulling" a large part of the efflux flow into the channel, enhances the velocity profile shape. Consequently, this coupled action results in a high, essentially constant shear force over the surface region encompassing the film hole and channel.

By referring back to Figures 7 and 4, the above discussion can be extended to the entire wafer surface bounding the upper side of the control volume, the resultant planar force vector at a film hole is denoted by P, and its axial and transverse components by $P_a$ and $P_t$ respectively. As shown, each film hole row and its channel is opposed by an equal such arrangement located at the same distance and at the opposite side of the symmetry axis. In the illustrated track configuration, there are three pairs of symmetrically opposed film hole row-channel arrangements. Their spacing on the axis is essentially uniform with respect to the wafer diameter. The manifold pressure (i.e., film hole flow rate) is smallest for the innermost film hole rows and largest for the outermost rows. Correspondingly, the sum of the P forces for an innermost film hole row is smaller than that for the outermost row. Now, when the wafer center is on the axis of symmetry, the sum of the $P_t$ forces on one side of the symmetry axis is just balanced by the sum of $P_t$ on the opposite side. Denoting the sum of the $P_t$ forces acting on one half of the wafer surface by $R_t$ it is seen that $\Delta R_t = 0$ for the above symmetrical case. Now, if the wafer shifts in the transverse direction, an unbalanced situation in $R_t$ results due to two reasons. First the wafer encounters increasingly higher $P_t$ forces in the transverse direction due to the manifold pressure settings discussed above. Second, more surface area of the wafer is exposed to the film hole effect in the shift direction. Consequently, an unbalanced force $\Delta R_t$ results which acts to return the wafer to the symmetry position.

The action of the $R_t$ transverse constraining force is illustrated in Figure 10. As shown, the wafer moving axially along the track is continuously subjected to the centering $R_t$ force field. Any tendency for the wafer to travel in the transverse direction produces a $\Delta R_t$ force that acts to bring its c.g. on the symmetry axis as it moves in the axial direction. The variation of $\Delta R_t$ with wafer displacement in the transverse direction is sketched in Figure 11. Once an axially moving wafer is displaced transversely, it is desirable to restore its motion back to the symmetry axis in the shortest possible downstream axial distance. The characteristics of the $\Delta R_t$ field are very effective in accomplishing this action.

Referring again to Figure 10 the sum of the axial force components $P_a$ is denoted by $R_a$. This unbalanced force scheme moves the wafer on the air film along the axis of symmetry while its motion in other directions is constrained as discussed above.

The hole pattern construction described above in connection with Figures 1, 1A and 12 represents a reduction of approximately 50% in holes per unit track length L as compared to the construction of U.S. Patent No. 4 081 201 to Hassan et al. This pattern is structured in a way such that two different sizes of wafers can be accommodated by the same track. For example, wafers of 57 and 83 mm (2.25 and 3.25 inches) in diameter can be transported on the track at the same supply air flow conditions. For a track design in which only a single size wafer is to be transported, even further constructional simplification can be achieved in the hole pattern. One such construction is illustrated in Figure 13 which shows a track segment of length L embodying a symmetrical arrangement of transverse pairs of rows of holes. The holes in each row are spaced apart by a distance "x" which is the same for each pair of rows. The holes in adjacent rows are longitudinally displaced by a distance "y", which is the same for each adjacent row. That is the longitudinal displacement between row 3 and row 2 (y3-2) is the same as y2-1 and y1-3. In contrast to the pattern of Figure 1A, each column contains only two holes and consequently this structure represents a reduction of approximately 67% in holes per unit track length L, relative to that of the aforementioned patent.

The above track constructions embodying a greatly reduced number of air film holes are thus more economical to produce. Because of the reduced number of holes, the air supply requirements for a track installation are substantially decreased. Furthermore, because of the particular hole patterns and hole angle relationships, coupled with a marked decrease in cross-interference flow action between holes a greatly improved wafer stability and motion control capability is achieved. Thus, the overall multiple hole structure represents a particularly advantageous arrangement where the desired axi-radial and Coanda flow effects are maximized while the dissipative and necessary cross-interference flow effects are minimized.

The above air film embodies unique characteristics of concurrently acting normal-direction and planar forces acting on a moving wafer. It is thus capable of exerting multidirectional constraint on a wafer moving in a prescribed manner. For linear wafer motion, the force field constrains its transverse and normal direction motions in a stable manner. For rotational motion, in a particular variation of the film surface shown in Figure 1, the force field acts radially and normally to provide precise, stable rotation with respect to the symmetry axes of the surface. The generic air film surface can take different forms depending on the application and/or emphasis on certain control properties (e.g., air tracks, intersections, orientors).

By this basic configuration, a unique air film is generated having multidirectional wafer motion control properties. This film surface, based on a synthesis of two fluid mechanics phenomena, can take various forms depending on the application. The key feature of its operation resides in the effective coupling of the axi-radial and Coanda flow characteristics. The fundamental surface construction feature by which this is accomplished is illustrated, in essence, by flat surface regions containing long, thin air film holes interrupted by channels having a certain cross-sectional shape. Among the important geometric quantities are included the film hole diameter, length, and inclination; the extent of the flat surfaces containing the film holes; the dimensions of the channel cross-section; and, the spacing arrangements of the film hole rows and channels with respect of the wafer surface. Some of the fluid mechanics parameters include air flow rate supply and distribution to various film hole regions.

**Claims**

1. A device for transporting objects (12) on a bed of a gaseous fluid comprising a substantially elongated transporting track (14) having rows of holes (20) extending longitudinally, the rows being arranged symmetrically in pairs about a center line (24) and each row being separated from adjacent rows by parallel channels (26), said holes in each row being spaced longitudinally at equal distances along said track, characterized in that said holes (20) in each row on each side of said center line (24) are longitudinally spaced from the holes in each adjacent row, such that a series of imaginary lines joining adjacent holes across the width of the device are parallel and form a regular herring-bone pattern swept-back in the direction of transport and symmetrical about said center line (24), whereby the spacing distance between the holes (20) in each is X and the longitudinal spacing distance between adjacent holes in each two adjacent rows is a constant distance of from about X/4 to about 3X/4, preferably X/2.

2. The device of claim 1, wherein the passages to the holes (20) are inclined both toward the center line (24) of the track (14) and in the direction of desired transportation down the track to provide both motion and stabilizing forces to the transported object (12).

3. The device of any preceding claim, wherein the inclination of the passages to the holes (20) in the direction of the center line (24) is less in any given row of passages than it is in a row of passages which is further from said center line of the track (14).

4. The device of any preceding claim, wherein there are two pairs of rows of holes (20) spaced equidistantly on each side of the center line (24).

5. The device of any of claims 1 through 3, wherein there are three pairs of rows of holes (20) spaced equidistantly on each side of the center line (24).

6. The device of any preceding claim, wherein the inclination of the passage to the holes (20) in the direction of transport is greater in any given row of passages than it is in a row of passages further from the center line (24) of the track (14).

7. The device of any preceding claim, wherein supply means is provided for supplying gaseous fluid under greater pressure to any given row of passages to holes (20) than is supplied to a row of passages that is closer to the center line (24) of the track (14).

8. The device of claim 4 or 5, wherein the holes (20) in each pair of rows are offset or spaced longitudinally with respect to each adjacent row of holes (Fig. 13), such that there is only one symmetrically located pair of holes in each track segment shorter than X.

**Patentansprüche**

1. Vorrichtung zum Transport von Gegenständen (12) auf einer Unterlage aus einem gasförmigen Medium, mit einer im wesentlichen langgestreckten Transportspur (14) mit sich längs erstreckenden Reihen aus Löchern (20), wobei diese Reihen symmetrisch paarweise längs einer Mittellinie (24) angeordnet sind und jede Reihe von benachbarten Reihen durch parallele Kanäle (26) getrennt ist, und wobei die Löcher in jeder Reihe längs in gleichmäßigen Abständen entlang der Spur angeordnet sind, dadurch gekennzeichnet, daß die Löcher (20) in jeder Reihe auf jeder Seite der Mittellinie (24) von den Löchern in jeder benachbarten Reihe längs beabstandet sind, in solcher Weise, daß eine Reihe imaginärer, sich an benachbarte Löcher über die Breite der Vorrichtung anschließender Leitungen parallel angeordnet sind und ein regelmäßiges Fischgrätmuster bilden, welches in die Transportrichtung weist und symmetrisch längs der Mittelline (24) angeordnet ist, wodurch der Abstand zwischen den Löchern (20) in jeder Reihe X beträgt und der Längsabstand zwischen benachbarten Löchern in jeweils zwei benachbarten Reihen eine konstante Entfernung zwischen ungefähr X/4 und ungefähr 3X/4 beträgt, bevorzugt X/2.

2. Vorrichtung nach Anspruch 1, worin die Kanäle zu den Löchern (20) geneigt sind, und zwar sowohl zur Mittellinie (24) der Spur (14) als auch in die gewünschte Transportrichtung entlang der Spur, um dem transportierten Gegenstand (12) Bewegung wie auch Stabilisierungskräfte zu vermitteln.

3. Vorrichtung nach einem der vorhergehenden Ansprüche, worin die Neigung der Kanäle zu den Löchern (20) in Richtung der Mittellinie (24) in jeder gegebenen Kanalreihe geringer ist als in einer Kanalreihe, die sich von der Mittellinie der Spur (14) weiter entfernt befindet.

4. Vorrichtung nach einem der vorhergehenden Ansprüche, worin zwei Reihenpaare mit Löchern (20) in gleicher Entfernung auf jeder Seite der Mittellinie (24) beabstandet sind.

5. Vorrichtung nach einem der Ansprüche 1 bis 3, worin drei Reihenpaare mit Löchern (20) in gleichem Abstand auf jeder Seite der Mittellinie (24) beabstandet sind.

6. Vorrichtung nach einem der vorhergehenden Ansprüche, worin die Neigung des Kanals zu den Löchern (20) in Transportrichtung stärker ist in jeder gegebenen Kanalreihe als in einer Kanalreihe, welche sich weiter entfernt von der Mittellinie (24) der Spur (14) befindet.

7. Vorrichtung nach einem der vorhergehenden Ansprüche, womit mittels einer Zuführvorrichtung gasförmiges Medium unter größerem Druck einer bestimmten Reihe von Kanälen nach den Löchern (20) zugeführt wird als zu einer Kanalreihe, die sich näher bei der Mittellinie (24) der Spur (14) befindet.

8. Vorrichtung nach Anspruch 4 oder 5, worin die Löcher (20) in jedem Reihenpaar versetzt oder längs beabstandet sind in bezug auf jede benachbarte Lochreihe (Fig. 13), so daß sich in jedem Spursegment, das kürzer ist als X, nur ein symmetrisch vorgesehenes Lochpaar befindet.

**Revendications**

1. Dispositif pour le transport d'objets (12) sur un lit d'un fluide gazeux, comportant une piste de transport (14) essentiellement allongée et comportant des rangées de trous (20), disposées longitudinalement, ces rangées étant disposées symétriquement par couples par rapport à un axe central (24) et chaque rangée étant séparée de rangées voisines par des canaux parallèles (26), lesdits trous situés dans chaque rangée étant équidistants longitudinalement le long de ladite piste, caractérisé en ce que lesdits trous (20) de chaque rangée de chaque côté dudit axe central (24) sont distants longitudinalement des trous situés dans chaque rangée voisine de telle sorte qu'une suite de droites imaginaires reliant des trous voisins suivant la direction transversale du dispositif, sont parallèles et forment un réseau régulier en arête de poisson, s'étendant à la manière d'une flèche pointée suivant la direction de transport et symétrique par rapport audit axe central (24), ce qui a pour effet que la distance de séparation des trous (20) dans chaque rangée est égale à X et la distance de séparation longitudinale de trous voisins dans chaque ensemble de deux rangées voisines possède une valeur constante comprise entre environ X/4 et environ 3X/4, et égale de préférence à X/2.

2. Dispositif selon la revendication 1, dans lequel les passages aboutissant aux trous (20) sont tous inclinés en direction de l'axe central (24) de la piste (14), et dans le sens de la direction de transport désirée, vers l'aval de la piste de manière à appliquer à la fois des forces de déplacement et de stabilisation à l'objet transporté (12).

3. Dispositif selon l'une quelconque des revendications précédentes, dans lequel l'inclinaison des passages aboutissant aux trous (20) par rapport à la direction de l'axe central (24) est plus faible dans n'importe quelle rangée donnée de passages que ce n'est le cas dans une rangée de passages qui est plus éloignée dudit axe central de la piste (14).

4. Dispositif selon l'une quelconque des revendications précédentes, selon lequel il existe deux paires de rangées de trous (20) équidistantes, de chaque côté de l'axe central (24).

5. Dispositif selon l'une quelconque des revendications 1 à 3, dans lequel il existe trois couples de rangées de trous (20) équidistantes de chaque côté de l'axe central (24).

6. Dispositif selon l'une quelconque des revendications précédentes, dans lequel l'inclinaison du passage aboutissant aux trous (20) par rapport à la direction de transport est plus importante pour n'importe quelle rangée donnée de passages, que ce n'est le cas pour une rangée de passages plus écartée de l'axe central (24) de la piste (14).

7. Dispositif selon l'une quelconque des revendications précédentes, dans lequel des moyens d'alimentation sont prévus en vue de délivrer un fluide gazeux sous un pression plus importante, pour n'importe quelle rangée donnée de passages aboutissant aux trous (20), que la pression délivrée à une rangée de passages qui est plus rapprochée de l'axe central (24) de la piste (14).

8. Dispositif selon la revendication 4 ou 5, dans lequel les trous (20) de chaque couple de rangées sont décalés ou espacés longitudinalement par rapport à chaque rangée voisine de trous (figure 13), de sorte qu'il n'existe qu'un couple de trous disposés symétriquement dans chaque segment de piste d'une longueur inférieure à X.

**0 043 457**

1/5

FIG. 1

FIG. 2

FIG. 3

AIR FILM

FLUID SHEAR FORCE, P

VELOCITY PROFILE IN Z-DIRECTION AT LOCATION i (SEE FIG. 4)

FIG. 9

STATIC PRESSURE (GAGE)

SUCTION

atm

CURVED SURFACE EFFECT

DISTANCE

FIG. 6

FIG. 1A

FIG. 13

FIG. 4

FIG. 5

FIG. 7

$\sum P_n = W + F_S$

EQUILIBRIUM AIR
FILM THICKNESS

OPERATING
REGION

0  SUPPLY AIR FLOWRATE TO TRACK

FIG. 8

TRACK

14

12

$R_a$

C.G.

$R_t$        $R_t$

12

$\Delta R_t$

t

FIG. 10

TRANSVERSE
CONSTRAINING FORCE
ON WAFER

$\Delta R_t$

C.G.

0   WAFER DISPLACEMENT

t

FIG. 11

4

**FIG. 12**